# EUROPEAN PATENT APPLICATION

(11) **EP 2 682 499 A1**
(43) Date of publication of application: **08.01.2014**
(21) Application number: 12752228.2
(22) Date of filing: 15.02.2012
(51) Int. Cl.: C23C 14/34, C22C 9/00, C22F 1/08, H01L 21/28, H01L 21/285, H01L 21/3205, H01L 23/52, C22F 1/00

(54) **COPPER-TITANIUM ALLOY SPUTTERING TARGET, SEMICONDUCTOR WIRING LINE FORMED USING THE SPUTTERING TARGET, AND SEMICONDUCTOR ELEMENT AND DEVICE EACH EQUIPPED WITH THE SEMICONDUCTOR WIRING LINE**

(30) Priority: 01.03.2011 JP 2011044481
(71) Applicant: JX Nippon Mining & Metals Corporation, Tokyo 100-8164 (JP)
(72) Inventor: OTSUKI Tomio, Kitaibaraki-shi Ibaraki 319-1535 (JP); FUKUSHIMA Atsushi, Kitaibaraki-shi Ibaraki 319-1535 (JP)
(74) Representative: Hoarton, Lloyd Douglas Charles
(86) International application number: PCT/JP2012/053502
(87) International publication number: WO 2012/117853

(57) **Abstract**

A copper-titanium alloy sputtering target comprising 3 at% or more and less than 15 at% of Ti and a remainder made up of Cu and unavoidable impurities, wherein a variation (standard deviation) in hardness is within 5.0 and a variation (standard deviation) in electric resistance is within 1.0 in an in-plane direction of the target. Provided are: a sputtering target for forming a copper-titanium alloy wiring line for semiconductors capable of causing the copper alloy wiring line for semiconductors to be equipped with a self-diffusion suppressive function, effectively preventing contamination around the wiring line caused by diffusion of active Cu, improving electromigration (EM) resistance, corrosion resistance and the like, enabling the arbitrary formation of a barrier layer in a simple manner, and uniformizing film properties; a copper-titanium alloy wiring line for semiconductors; and a semiconductor element and a device each equipped with the semiconductor wiring line.

## Description

### TECHNICAL FIELD

The present invention relates to a sputtering target for forming a copper alloy wiring line for semiconductors capable of effectively preventing contamination around the wiring line caused by diffusion of active Cu, and particularly relates to a copper-titanium (Cu-Ti) alloy sputtering target suitable for forming a semiconductor wiring line equipped with a self-diffusion suppressive function, a copper-titanium alloy sputtering target capable of uniform sputter deposition and thereby obtaining uniform film properties, a semiconductor wiring line formed using the foregoing sputtering target, and a semiconductor element and a device each equipped with the foregoing semiconductor wiring line.

### BACKGROUND ART

Conventionally, Al alloy (specific resistance of roughly 3.0 µΩ·cm) had been used as the wiring line material of a semiconductor element, but pursuant to finer wiring lines, a copper wiring line with lower resistance (specific resistance of roughly 1.7 µΩ·cm) has been put into practical use. As the current process of forming copper wiring lines, generally performed is the process of forming a diffusion barrier layer made of Ta or TaN in contact holes or the concave part of a wiring gutter, and thereafter performing sputter deposition of copper or copper alloy.

Normally, as the crude metal, electrolytic copper having a purity of roughly 4N (excluding gas components) was subject to a wet or dry purification process to produce high-purity copper having a purity of 5N to 6N, and the obtained high-purity copper was used as the sputtering target.

While copper or copper alloy is extremely useful as a wiring line material for semiconductors, since copper itself is an extremely active metal that diffuses easily, there is a problem in that copper contaminates the semiconductor Si substrate, or contaminates the Si substrate or the periphery thereof through the insulating film formed on the Si substrate. Thus, with conventional technologies, the formation of a diffusion barrier layer made of Ta or TaN is an unavoidable process. Nevertheless, this is not necessarily the ideal means since there is the problem of the number of processes increasing by that much. Thus, in substitute for this diffusion barrier layer, proposed is depositing a copper alloy and forming a self-forming diffusion barrier layer based on heat treatment, but the current situation is that there is no simple and effective means for preventing the foregoing problem.

Meanwhile, previously proposed is forming, via sputtering, a copper alloy thin film, in which titanium is added to copper, as a copper wiring line material.

These examples are listed below. Patent Document 1 proposes a method of producing a Cu alloy thin film containing 0.5 to 10 at% of Ti, and a semiconductor wiring line formed by sputter-depositing the foregoing Cu alloy thin film.

Patent Document 2 proposes forming a Cu alloy film containing 0.5 to 3 at% of Ti and 0.4 to 2.0 at% of N under an inert gas atmosphere containing 2.5 to 12.5 vol% of N₂.

Patent Document 3 proposes a Cu wiring line containing Ti, and a semiconductor wiring line containing 15 at% or less, preferably 13 at% or less, and more preferably 10 at% or less of Ti.

In addition, Non-Patent Document 1 proposes a self-forming barrier film using a Cu-Ti alloy.

The foregoing Cu alloy containing Ti as a wiring line material is useful for forming a semiconductor wiring line equipped with a self-diffusion suppressive function. Moreover, since the formation of this Cu alloy wiring line via sputtering facilitates the thickness control of the thin film and improves the production efficiency, it could be said that the utility value is high. It could be said that the foregoing public technologies result from the research and study of functions as a semiconductor wiring line.

Nevertheless, a Cu alloy sputtering target containing a certain level of Ti had a problem in that the uniformity of the film properties was inferior in comparison to a copper sputtering target.

While this will not raise any particular issue in a stage where no special focus is given to the foregoing problem, today when the copper wiring lines are becoming even finer, the foregoing problem is considered to be a major problem since the film properties directly affect the semiconductor wiring line.

Accordingly, simultaneously with researching the problem of non-uniform film properties, it was necessary to discover a solution for reforming the sputtering target and discover the properties required in a target itself so that the foregoing problem could be resolved.

Patent Document 1: JP2008-21807 A
Patent Document 2: JP2007-258256 A
Patent Document 3: International Publication No. 2010/007951

Non-Patent Document 1: By Kazuyuki Ohmori and 9 others, "Properties of Dual Damascene Cu Wiring Lines using Ti Alloy-based Self-forming Barrier", Edited by the Institute of Electronics, Information and Communication Engineers, Technical Report of IEICE, Pages 37-40

### SUMMARY OF INVENTION

### [Technical Problem]

An object of this invention is to discover the properties required in a target itself so that such target will be capable of causing the copper alloy wiring line for semiconductors to be equipped with a self-diffusion suppressive function, effectively preventing contamination around the wiring line caused by diffusion of active Cu, resolving the issue of non-uniformity of the film properties, and reforming the sputtering target. Another object of the present invention is to provide a copper-titanium alloy sputtering target for semiconductor wiring lines capable of improving the electromigration (EM) resistance, corrosion resistance and the like.

### [Solution to Problem]

In order to resolve the foregoing problems, as a result of intense study, the present inventors discovered that the uniformity of the sputtered film properties can be realized by uniformizing the sputtering target structure (composition); that is, by strictly controlling the variation (standard deviation) in the hardness and the variation (standard deviation) in the electric resistance in the in-plane direction of the target.

Moreover, the present invention aims to provide a copper-titanium alloy sputtering target capable of effectively preventing the contamination around the wiring line caused by the diffusion of active Cu, a semiconductor wiring line formed by using the foregoing sputtering target, and a semiconductor element and a device each equipped with the foregoing semiconductor wiring line.

Based on the foregoing discovery, the present invention provides:
1) A copper-titanium alloy sputtering target comprising 3 at% or more and less than 15 at% of Ti and a remainder made up of Cu and unavoidable impurities, wherein a variation (standard deviation) in hardness is within 5.0 and a variation (standard deviation) in electric resistance is within 1.0 in an in-plane direction of the target.

The present invention further provides:
2) The copper-titanium alloy sputtering target according to 1) above, wherein an average crystal grain size of the target is 5 to 50 µm.

The present invention additionally provides:
3) A copper-titanium alloy semiconductor wiring line formed by using the copper-titanium alloy sputtering target according to 1) or 2) above; and
4) A semiconductor element or a device comprising the copper-titanium alloy semiconductor wiring line according to 3) above.

### [Effects of Invention]

The copper alloy wiring line for semiconductors and the sputtering target for forming the foregoing wiring line according to the present invention yield superior effects of being able to cause the copper alloy wiring line for semiconductors to be equipped with a self-diffusion suppressive function, effectively prevent contamination around the wiring line caused by diffusion of active Cu, and uniformize the sputtered film properties. The present invention additionally yields the effect of being able to improve the electromigration (EM) resistance, corrosion resistance and the like.

### BRIEF DESCRIPTION OF DRAWINGS

[Fig. 1] This is a schematic explanatory diagram showing an example of using a graphite vessel (crucible) to melt Cu, and adding a prescribed amount of Ti to the Cu molten metal.
[Fig. 2] This is a phase diagram of the Cu-Ti binary system alloy.
[Fig. 3] This is a schematic explanatory diagram of the production process from melting the copper-titanium alloy to obtaining a sputtering target.
[Fig. 4] These are structure photographs of the Cu-3.0% Ti and Cu-5.0% Ti targets.
[Fig. 5] This is a diagram showing the measurement points of hardness and electric resistance of the target in-plane.

### DESCRIPTION OF EMBODIMENTS

Copper (pure copper) entails a problem of reaching the insulating layer or semiconductor Si substrate, and easily becoming a contamination source. This problem has been indicated from the past, and a proposed solution thereof was that a barrier layer is formed between the insulating film and the copper wiring line film.

As representative examples of this barrier film, there are: metals such as Zr, Ti, V, Ta, Nb, and Cr; or nitride; or boride. Nevertheless, with these elements, since the crystal grain size in the thin film would increase, they were unsuitable as a barrier film against Cu.

In addition, this process entailed a problem in that the barrier film needed to be formed in a separate coating process, and this process itself does not yield the effect of inhibiting the diffusion of Cu itself. Accordingly, contamination may occur as a matter of course at portions other than where the barrier film was formed. Thus, the foregoing proposal had disadvantages in that the barrier effect is limited and high costs are required.

As described above, the present invention inhibit the diffusion of Cu itself as a result of obtaining a Cu-Ti alloy by incorporating Ti into Cu, and this effect can be continuously exhibited in all circumstances (faces) of the Cu-Ti alloy film. When the Ti in the Cu-Ti alloy film is diffuses and reaches the interface of the Si semiconductor, oxides of Ti and Si (nonstoichiometric oxides of TiSixOy) are formed. As a result of oxides being unevenly distributed at the interface, the conductivity of the center part of the wiring line is improved, and it could be said that this is a preferred reaction.

This layer is positioned at the interface of the Si semiconductor and the copper alloy conductive (wiring line) layer, and a layer of over 0 to about 2 nm is formed. Once this layer if formed, diffusion of Ti into the Si semiconductor layer is prevented. In other words, this becomes the barrier layer. Since this process generates a self-diffusion suppressive function by forming a copper alloy wiring line, it should be easy to understand that this process is extremely simple and effective.

Conventionally, while a Ta barrier layer had been used, in this case the Ta film needed to have a thickness of at least 15 nm because it needed to be formed in a separate sputtering process and because a uniform film needed to be formed in order to sufficiently maintain the functions as the barrier film. The superiority of the present invention is obvious in comparison to this kind of conventional Ta barrier layer.

Nevertheless, a particular problem in the sputtering target for producing a copper alloy wiring line for semiconductors is the non-uniformity of the sputtered film properties. It has been found that the foregoing problem is a result of the non-uniformity of the structure (composition) of the sputtering target; that is, the variation (standard deviation) in the hardness and the variation (standard deviation) in the electric resistance in the in-plane direction of the target.

Accordingly, as a means for resolving the foregoing problem, the copper-titanium alloy sputtering target of the present invention, which comprises 3 at% or more and less than 15 at% of Ti and, as the remainder, Cu and unavoidable impurities, has a variation (standard deviation) in hardness within 5.0 and a variation (standard deviation) in electric resistance within 1.0 in an in-plane direction of the target. It was thereby possible to resolve the non-uniformity of the target, and considerably reduce the non-uniformity of the film properties after sputtering. Note that, in the copper-titanium alloy sputtering target of the present invention, since the values of hardness and electric resistance in the in-plane direction of the target vary depending on the component composition and structural form, it would not be appropriate to evaluate these values as absolute values, and it would be appropriate to evaluate these values based on the variation thereof.

In addition, with the copper-titanium alloy sputtering target of the present invention, if the average crystal grain size is caused to be 5 to 50 µm, the plasma stability during sputtering can be improved and superior sputtering efficiency can be simultaneously yielded.

A copper-titanium alloy semiconductor wiring line formed by using the foregoing copper-titanium alloy sputtering target yields uniform film properties (in particular, film resistance). In addition, it is also possible to obtain a high-quality semiconductor element and a device each equipped with the copper-titanium alloy semiconductor wiring line.

As the process of forming the copper wiring line, generally performed is the process of forming a diffusion barrier layer made of Ta or TaN in contact holes (via holes) or the concave part of a wiring gutter, and thereafter performing sputter deposition of copper or copper alloy, but the present invention is not limited thereto. In other words, with the copper alloy wiring line for semiconductors of the present invention, a Ti oxide film, in which Ti in the copper alloy was subject to preferential oxidation (selective oxidation), may also be formed on the top face, side face and bottom face; that is, on the peripheral face, of the wiring line. This in itself can function as the barrier layer.

This Ti oxide film layer can be formed on the surface of the wiring line, for example, by once sputtering the target to form a copper alloy wiring line, and thereafter performing heat treatment thereto in an atmosphere containing oxygen so as to preferentially-oxidize the Ti in the copper alloy. This heat treatment is preferably performed in a range of 200 to 525°C. The formation of this kind of barrier layer does not require an additional thin film forming process, and yields a superior feature of being formed with an extremely simple process.

As the method of forming a copper alloy wiring line for semiconductors in the present invention, the sputtering method enables the deposition most efficiently and stably. Accordingly, a target having the foregoing composition is used in the foregoing method as the sputtering target for forming a copper alloy wiring line for semiconductors equipped with a self-diffusion suppressive function.

Since this kind of component composition of the target will be directly reflected on the sputtered film, it must be managed sufficiently. Moreover, the amount to be added is decided based on the same reasons as those explained above with regard to the wiring line film.

When producing a copper-titanium alloy, the titanium (Ti) can be easily melted in the copper (Cu) if Ti is of a low concentration. Meanwhile, if Ti is of a high concentration (5% or more), since the melting point of Cu is 1085°C and considerably differs from the melting point of Ti which is 1670°C, when vacuum melting is performed at the melting point of the high-melting-point metal upon preparing a metal alloy, the low-melting-point metal will evaporate, and there is a problem in that the intended composition cannot be obtained.

Upon producing the copper-titanium alloy sputtering target of the present invention, which comprises 3 at% or more and less than 15 at% of Ti and, as the remainder, Cu and unavoidable impurities; Cu is melted in a graphite vessel (crucible) that was subject to vacuum drawing in advance, the vessel is subsequently made to an Ar gas atmosphere, and the molten metal is agitated with the addition of Ti via natural convection so as to melt Ti in Cu.

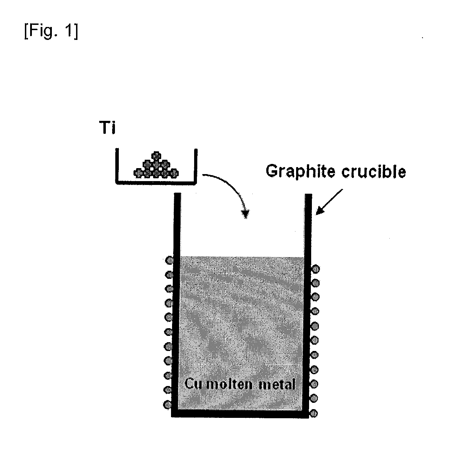

In addition, the molten metal is tapped into a Cu mold and solidified to obtain a copper-titanium alloy ingot. The state where Ti is poured into the graphite vessel (crucible) is shown in Fig. 1.

As described above, by adding Ti to the Cu molten metal maintained at a temperature that is slightly higher than the melting point, it is possible to cause the surface of Ti to gradually react with Cu to become alloyed.

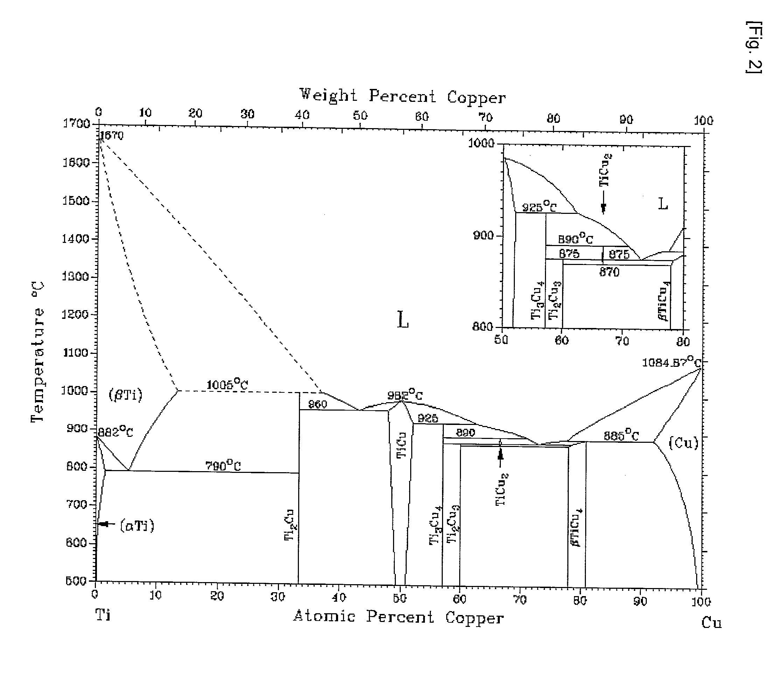

Fig. 2 shows a phase diagram of the Cu-Ti binary system alloy. As shown in Fig. 2, since the melting point of Ti will decrease due to the alloying, the alloyed surface melts in the Cu molten metal, and ultimately Ti becomes entirely melted in Cu. Cu will not evaporate because Ti is melted at a temperature that is slightly higher than the melting point of Cu, and it is thereby possible to prepare an alloy of the intended composition.

Melting of Cu is normally performed via vacuum induction melting. The melting conditions can be arbitrarily changed based on the amount of material to be melted and the melting equipment. Subsequently, Ti is added after introducing the Ar gas atmosphere.

Agitation is preferably carried out via natural convection. After retention for roughly 15 minutes after adding Ti, the molten metal is tapped into a mold and solidified. The tapping temperature is 1100 to 1250°C.

When melting Cu, melting is desirably performed in a temperature range that is +200°C or less from the melting point of Cu. Moreover, it is also desirable that Ti is added to the melted copper retained at a temperature range that is +200°C or less from the melting point of Cu. Consequently, Ti and Cu will gradually melt while becoming alloyed, and Ti ultimately becomes entirely melted in the molten Cu.

The copper-titanium alloy produced as described above is subject to hot forging (for instance, forging at 700 to 950°C), rolling (for instance, hot rolling at 700 to 950°C) and heat treatment (for instance, heat treatment at 700 to 950°C for 1 to 3 hr) so as to produce a copper-titanium alloy sputtering target comprising 3 at% or more and less than 15 at% of Ti and a remainder made up of Cu and unavoidable impurities.

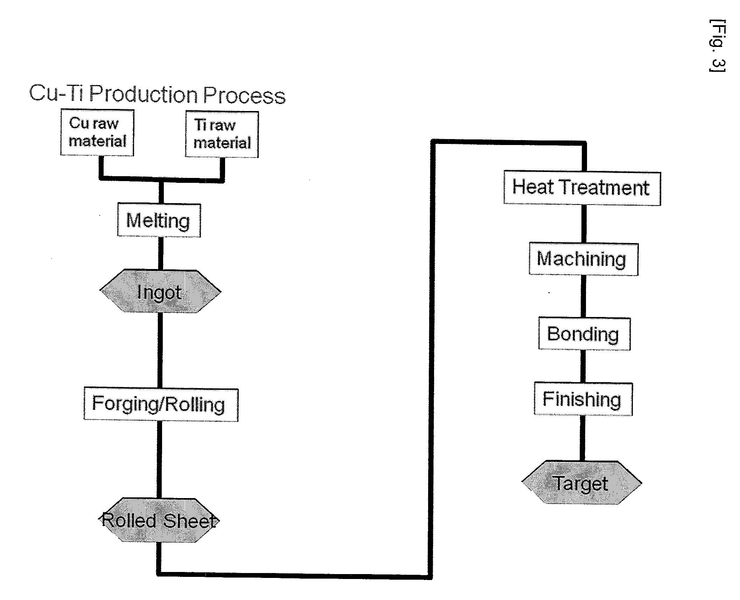

This process is shown in Fig. 3. After the heat treatment is performed, normal processes such as machining, bonding to a backing plate, and finishing are performed to obtain a target.

In the foregoing process, forging is performed as hot forging at 700 to 950°C. It is thereby possible to obtain a target with a uniform structure having a crystal grain size of 5 to 50 µm.

In addition, it becomes possible to cause the variation (standard deviation) in hardness and the variation (standard deviation) in electric resistance in an in-plane direction of the target to be within 5.0 and within 1.0, respectively.

### [Examples]

The present invention is now explained with reference to the Examples. The following Examples are described for facilitating the understanding of this invention, and these Examples are not intended to limit the present invention in any way. In other words, modifications and other examples that are based on the technical concept of this invention are also covered by the present invention as a matter of course.

### (Example 1)

In order to produce a sputtering target comprising 3.0 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1250°C, Ar gas was introduced, and Ti was added. Agitation was performed via natural convection. Time from the addition of Ti to metal tapping was 12 minutes. A copper mold was used, the tapping temperature was set to 1100 to 1250°C, and the molten metal was solidified therein.

The solidified ingot was subject to forging at 700 to 950°C, and the thickness was thereby reduced from 100 mmt to 70 mmt. This was further subject to hot rolling at 700 to 950°C, and the thickness was further reduced from 70 mmt to 12 mmt. Subsequently, this was subject to heat treatment at 700 to 950°C × 1 hr.

In addition, this was subject to machining, bonding to a backing plate, and finishing to obtain an assembly of a disk-shaped target made from titanium-copper having a thickness of 7 mmt and a diameter of *φ* 300 mm and comprising Cu-3.0 at% Ti, and a backing plate.

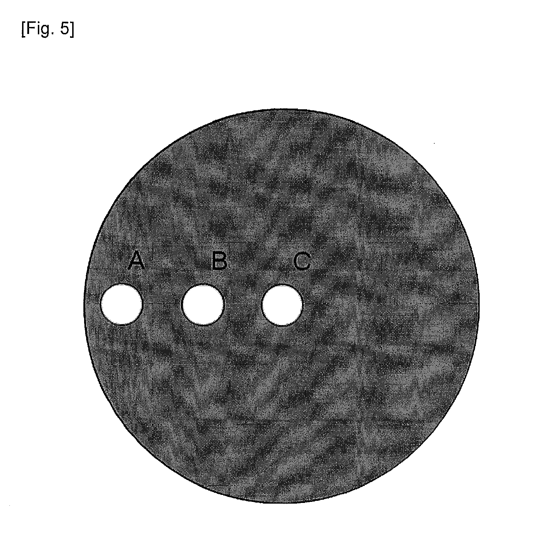

The physical properties of the target made from titanium-copper comprising Cu-3.0 at% Ti are shown in Table 1. Note that Fig. 5 shows the measurement points of hardness and electric resistance of the target in-plane.

The hardness of the titanium-copper target comprising Cu-3.0 at% Ti was 201.0 Hv (three-point average value), and the in-plane variation (standard deviation) in the hardness was 3.99. Moreover, the electric resistance was 10.8 µΩ (three-point average) in the target, and the in-plane variation (standard deviation) in the electric resistance was 0.32.

In addition, this target was used to perform sputtering with a power supply of 38 kW and for a sputtering time of 6.5 seconds, and variation in the film properties was measured.

The standard deviation of the variation in the film properties (film resistance) was 3.42. All of these values were within the scope of properties of the present invention, and favorable results were attained. Note that the variation in the film resistance is a result of measuring the standard deviation of the numerical values obtained by measuring the resistance values of 49 locations on a wafer (four-terminal method) using Omnimap (RS-100) manufactured by KLA-TENCOR. Variation in the film resistance was measured with the same method in the ensuing Examples and Comparative Examples.

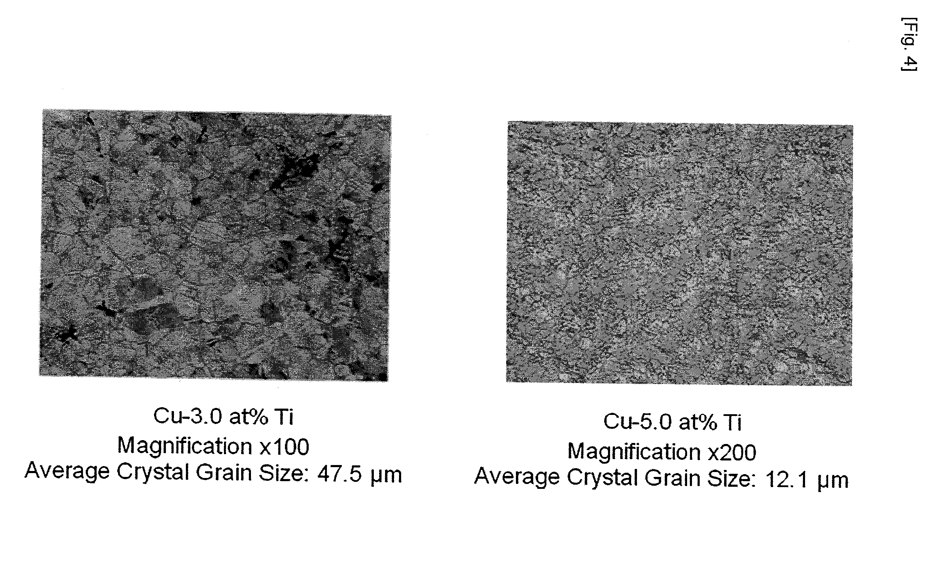

In addition, the microscopic structure photograph of the target comprising Cu-3.0 at% Ti is shown in Fig. 4 (left side of the diagram). The average crystal grain size was 47.5 µm.

**[Table 1]**

| | Component Composition | | Hardness | | Electric Resistance | | Film property (film resistance) variation (standard deviation) |
|---|---|---|---|---|---|---|---|
| | Ti concentration | Remainder | 3-point average value | In-plane variation (standard deviation) | 3-point average value | In-plane variation (standard deviation) | |
| Example 1 | 3.0 | Cu | 201.0 | 3.99 | 10.8 | 0.32 | 3.42 |
| Example 2 | 5.0 | Cu | 233.0 | 4.38 | 13.6 | 0.26 | 3.29 |
| Example 3 | 7.0 | Cu | 239.0 | 4.49 | 16.3 | 0.45 | 4.03 |
| Example 4 | 10.0 | Cu | 243.0 | 4.63 | 17.6 | 0.67 | 4.35 |
| Comparative Example 1 | 2.5 | Cu | 196.0 | 5.24 | 9.2 | 2.00 | 5.21 |
| Comparative Example 2 | 3.2 | Cu | 210.0 | 5.42 | 11.8 | 1.82 | 5.54 |
| Comparative Example 3 | 6.8 | Cu | 236.0 | 5.85 | 14.6 | 1.78 | 5.33 |
| Comparative Example 4 | 9.1 | Cu | 238.0 | 6.33 | 18.5 | 2.02 | 6.04 |
| Comparative Example 5 | 15.0 | Cu | 257.0 | 7.38 | 19.7 | 2.48 | 6.31 |

### (Example 2)

In order to produce a sputtering target comprising 5.0 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1250°C, Ar gas was introduced, and Ti was added. Agitation was performed via natural convection. Time from the addition of Ti to metal tapping was 12 minutes. A copper mold was used, the tapping temperature was set to 1100 to 1250°C, and the molten metal was solidified therein.

The solidified ingot was subject to forging at 700 to 950°C, and the thickness was thereby reduced from 100 mmt to 70 mmt. This was further subject to hot rolling at 700 to 950°C, and the thickness was further reduced from 70 mmt to 12 mmt. Subsequently, this was subject to heat treatment at 700 to 950°C × 1 hr.

In addition, this was subject to machining, bonding to a backing plate, and finishing to obtain an assembly of a disk-shaped target made from titanium-copper having a thickness of 20 mmt and a diameter of *φ* 300 mm and comprising Cu-5.0 at% Ti, and a backing plate.

The physical properties of the target made from titanium-copper comprising Cu-5.0 at% Ti are similarly shown in Table 1. Note that Fig. 5 shows the measurement points of hardness and electric resistance of the target in-plane.

The hardness of the titanium-copper target comprising Cu-5.0 at% Ti was 233.0 Hv (three-point average value), and the in-plane variation (standard deviation) in the hardness was 4.38. Moreover, the electric resistance was 13.6 µΩ (three-point average) in the target, and the in-plane variation (standard deviation) in the electric resistance was 0.26.

In addition, this target was used to perform sputtering in the same manner as Example 1, and variation in the film properties was measured. The standard deviation of the variation in the film properties (film resistance) was 3.29. All of these values were within the scope of properties of the present invention, and favorable results were attained.

Consequently, in comparison to the titanium-copper comprising Cu-3.0 at% Ti of Example 1, both the hardness and electric resistance value as the physical properties of the ingot and the target made from the titanium-copper comprising Cu-5.0 at% Ti of Example 2 had increased. This is a result of the increase in the Ti amount.

In addition, the microscopic structure photograph of the target comprising Cu-5.0 at% Ti is shown in Fig. 4 (right side of the diagram). The average crystal grain size was 12.1 µm.

### (Example 3)

In order to produce a sputtering target comprising 7.0 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1250°C, Ar gas was introduced, and Ti was added. Agitation was performed via natural convection. Time from the addition of Ti to metal tapping was 12 minutes. A copper mold was used, the tapping temperature was set to 1100 to 1250°C, and the molten metal was solidified therein.

The solidified ingot was subject to forging at 700 to 950°C, and the thickness was thereby reduced from 100 mmt to 70 mmt. This was further subject to hot rolling at 700 to 950°C, and the thickness was further reduced from 70 mmt to 12 mmt. Subsequently, this was subject to heat treatment at 700 to 950°C × 1 hr. In addition, this was subject to machining, bonding to a backing plate, and finishing to obtain an assembly of a disk-shaped target made from titanium-copper having a thickness of 20 mmt and a diameter of *φ* 300 mm and comprising Cu-7.0 at% Ti, and a backing plate.

The physical properties of the target made from titanium-copper comprising Cu-7.0 at% Ti are similarly shown in Table 1. Note that Fig. 5 shows the measurement points of hardness and electric resistance of the target in-plane.

The hardness of the titanium-copper target comprising Cu-7.0 at% Ti was 239.0 Hv (three-point average value), and the in-plane variation (standard deviation) in the hardness was 4.49. Moreover, the electric resistance was 16.3 µΩ (three-point average) in the target, and the in-plane variation (standard deviation) in the electric resistance was 0.45.

In addition, this target was used to perform sputtering in the same manner as Example 1, and variation in the film properties was measured. The standard deviation of the variation in the film properties (film resistance) was 4.03. All of these values were within the scope of properties of the present invention, and favorable results were attained.

Consequently, in comparison to the titanium-copper comprising Cu-3.0 at% Ti of Example 1, both the hardness and electric resistance value as the physical properties of the ingot and the target made from the titanium-copper comprising Cu-7.0 at% Ti of Example 3 had increased. This is a result of the increase in the Ti amount.

In addition, a target having a uniform structure was obtained, and the average crystal grain size was 10.8 µm.

### (Example 4)

In order to produce a sputtering target comprising 10.0 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1250°C, Ar gas was introduced, and Ti was added. Agitation was performed via natural convection. Time from the addition of Ti to metal tapping was 12 minutes. A copper mold was used, the tapping temperature was set to 1100 to 1250°C, and the molten metal was solidified therein.

The solidified ingot was subject to forging at 700 to 950°C, and the thickness was thereby reduced from 100 mmt to 70 mmt. This was further subject to hot rolling at 700 to 950°C, and the thickness was further reduced from 70 mmt to 12 mmt. Subsequently, this was subject to heat treatment at 700 to 950°C × 1 hr. In addition, this was subject to machining, bonding to a backing plate, and finishing to obtain an assembly of a disk-shaped target made from titanium-copper having a thickness of 20 mmt and a diameter of *φ* 300 mm and comprising Cu-10.0 at% Ti, and a backing plate.

The physical properties of the target made from titanium-copper comprising Cu-10.0 at% Ti are similarly shown in Table 1. Note that Fig. 5 shows the measurement points of hardness and electric resistance of the target in-plane.

The hardness of the titanium-copper target comprising Cu-10.0 at% Ti was 243.0 Hv (three-point average value), and the in-plane variation (standard deviation) in the hardness was 4.63. Moreover, the electric resistance was 17.6 µΩ (three-point average) in the target, and the in-plane variation (standard deviation) in the electric resistance was 0.67.

In addition, this target was used to perform sputtering in the same manner as Example 1, and variation in the film properties was measured. The standard deviation of the variation in the film properties (film resistance) was 4.35. All of these values were within the scope of properties of the present invention, and favorable results were attained.

Consequently, in comparison to the titanium-copper comprising Cu-3.0 at% Ti of Example 1, both the hardness and electric resistance value as the physical properties of the ingot and the target made from the titanium-copper comprising Cu-10.0 at% Ti had increased. This is a result of the increase in the Ti amount.

In addition, a target having a uniform structure was obtained, and the average crystal grain size was 10.3 µm.

### (Comparative Example 1)

Copper was melted via vacuum induction melting. 32187g of copper was used, and the vacuum degree was set to 0.05 Pa. After melting Cu, the molten metal was retained at 1100 to 1200°C, Ar gas was introduced, and, after obtaining an Ar atmosphere, Ti was added. Agitation was performed via natural convection. After Ti was added, the molten metal was retained for approximately 10 minutes, and thereafter tapped in a mold and solidified.

The solidified ingot was subject to hot rolling at 850 to 1000°C, and the thickness was thereby reduced from 100 mmt to 12 mmt. Subsequently, this was subject to heat treatment at 950 to 1000°C × 1 to 2 hr. In addition, this was subject to machining, bonding to a backing plate, and finishing to obtain an assembly of a disk-shaped target made from titanium-copper having a thickness of 7 mmt and a diameter of *φ* 300 mm and comprising Ti 5 at%-Cu, and a backing plate.

The physical properties of the target made from titanium-copper comprising Cu-2.5 at% Ti are shown in Table 1. Note that Fig. 5 shows the measurement points of hardness and electric resistance of the target in-plane. The hardness of the titanium-copper target comprising Cu-2.5 at% Ti was 196.0 Hv (three-point average value), and the in-plane variation (standard deviation) in the hardness was 5.24. Moreover, the electric resistance was 9.2 µΩ (three-point average) in the target, and the in-plane variation (standard deviation) in the electric resistance was 2.00.

In addition, this target was used to perform sputtering in the same manner as Example 1, and variation in the film properties was measured. The standard deviation of the variation in the film properties (film resistance) was 5.21. All of these values were outside the scope of properties of the present invention, and inferior results were attained.

### (Comparative Example 2)

In order to produce a sputtering target comprising 3.2 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1200°C, Ar gas was introduced, and, after obtaining an Ar atmosphere, Ti was added. Agitation was performed via natural convection. After Ti was added, the molten metal was retained for approximately 10 minutes, and thereafter tapped in a mold and solidified.

The solidified ingot was subject to hot rolling at 850 to 1000°C, and the thickness was thereby reduced from 100 mmt to 12 mmt. Subsequently, this was subject to heat treatment at 950 to 1000°C × 1 to 2 hr. In addition, this was subject to machining, bonding to a backing plate, and finishing to obtain an assembly of a disk-shaped target made from titanium-copper having a thickness of 7 mmt and a diameter of *φ* 300 mm and comprising Cu-3.2 at% Ti, and a backing plate.

The physical properties of the target made from titanium-copper comprising Cu-3.2 at% Ti are shown in Table 1. Note that Fig. 5 shows the measurement points of hardness and electric resistance of the target in-plane.

The hardness of the titanium-copper target comprising Cu-3.2 at% Ti was 210.0 Hv (three-point average value), and the in-plane variation (standard deviation) in the hardness was 5.42. Moreover, the electric resistance was 11.8 µΩ (three-point average) in the target, and the in-plane variation (standard deviation) in the electric resistance was 1.82.

In addition, this target was used to perform sputtering in the same manner as Example 1, and variation in the film properties was measured. The standard deviation of the variation in the film properties (film resistance) was 5.54. All of these values were outside the scope of properties of the present invention, and inferior results were attained.

### (Comparative Example 3)

In order to produce a sputtering target comprising 6.8 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1200°C, Ar gas was introduced, and, after obtaining an Ar atmosphere, Ti was added. Agitation was performed via natural convection. After Ti was added, the molten metal was retained for approximately 10 minutes, and thereafter tapped in a mold and solidified.

The solidified ingot was subject to hot rolling at 850 to 1000°C, and the thickness was thereby reduced from 100 mmt to 12 mmt. Subsequently, this was subject to heat treatment at 950 to 1000°C × 1 to 2 hr. In addition, this was subject to machining, bonding to a backing plate, and finishing to obtain an assembly of a disk-shaped target made from titanium-copper having a thickness of 7 mmt and a diameter of *φ* 300 mm and comprising Cu-6.8 at% Ti, and a backing plate.

The physical properties of the target made from titanium-copper comprising Cu-6.8 at% Ti are shown in Table 1. Note that Fig. 5 shows the measurement points of hardness and electric resistance of the target in-plane.

The hardness of the titanium-copper target comprising Cu-6.8 at% Ti was 236.0 Hv (three-point average value), and the in-plane variation (standard deviation) in the hardness was 5.85. Moreover, the electric resistance was 14.6 µΩ (three-point average) in the target, and the in-plane variation (standard deviation) in the electric resistance was 1.78.

In addition, this target was used to perform sputtering in the same manner as Example 1, and variation in the film properties was measured. The standard deviation of the variation in the film properties (film resistance) was 5.33. All of these values were outside the scope of properties of the present invention, and inferior results were attained.

### (Comparative Example 4)

In order to produce a sputtering target comprising 9.1 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1200°C, Ar gas was introduced, and, after obtaining an Ar atmosphere, Ti was added. Agitation was performed via natural convection. After Ti was added, the molten metal was retained for approximately 10 minutes, and thereafter tapped in a mold and solidified.

The solidified ingot was subject to hot rolling at 850 to 1000°C, and the thickness was thereby reduced from 100 mmt to 12 mmt. Subsequently, this was subject to heat treatment at 950 to 1000°C × 1 to 2 hr. In addition, this was subject to machining, bonding to a backing plate, and finishing to obtain an assembly of a disk-shaped target made from titanium-copper having a thickness of 7 mmt and a diameter of *φ* 300 mm and comprising Cu-9.1 at% Ti, and a backing plate.

The physical properties of the target made from titanium-copper comprising Cu-9.1 at% Ti are shown in Table 1. Note that Fig. 5 shows the measurement points of hardness and electric resistance of the target in-plane.

The hardness of the titanium-copper target comprising Cu-9.1 at% Ti was 238.0 Hv (three-point average value), and the in-plane variation (standard deviation) in the hardness was 6.33. Moreover, the electric resistance was 18.5 µΩ (three-point average) in the target, and the in-plane variation (standard deviation) in the electric resistance was 2.02.

In addition, this target was used to perform sputtering in the same manner as Example 1, and variation in the film properties was measured. The standard deviation of the variation in the film properties (film resistance) was 6.04. All of these values were outside the scope of properties of the present invention, and inferior results were attained.

### (Comparative Example 5)

In order to produce a sputtering target comprising 15.0 at% of Ti and a remainder made up of Cu, used as the raw materials were Cu having a purity of 6N and Ti having a purity of 5N.

Copper was melted via vacuum induction melting. 32187g of copper was used, and the vacuum degree was set to 0.05 Pa. After melting Cu, the molten metal was retained at 1100 to 1200°C, Ar gas was introduced, and, after obtaining an Ar atmosphere, Ti was added. Agitation was performed via natural convection. After Ti was added, the molten metal was retained for approximately 10 minutes, and thereafter tapped in a mold and solidified.

The solidified ingot was subject to hot rolling at 850 to 1000°C, and the thickness was thereby reduced from 100 mmt to 12 mmt. Subsequently, this was subject to heat treatment at 950 to 1000°C × 1 to 2 hr. In addition, this was subject to machining, bonding to a backing plate, and finishing to obtain an assembly of a disk-shaped target made from titanium-copper having a thickness of 7 mmt and a diameter of *φ* 300 mm and comprising Cu-15.0 at% Ti, and a backing plate.

The physical properties of the target made from titanium-copper comprising Cu-15.0 at% Ti are shown in Table 1. Note that Fig. 5 shows the measurement points of hardness and electric resistance of the target in-plane,

The hardness of the titanium-copper target comprising Cu-15.0 at% Ti was 257.0 Hv (three-point average value), and the in-plane variation (standard deviation) in the hardness was 7.38. Moreover, the electric resistance was 19.7 µΩ (three-point average) in the target, and the in-plane variation (standard deviation) in the electric resistance was 2.48.

In addition, this target was used to perform sputtering in the same manner as Example 1, and variation in the film properties was measured. The standard deviation of the variation in the film properties (film resistance) was 6.31. All of these values were outside the scope of properties of the present invention, and inferior results were attained.

### INDUSTRIAL APPLICABILITY

Since the copper alloy wiring line for semiconductors is independently equipped with a self-diffusion suppressive function, the present invention yields superior effects of being able to effectively prevent the contamination around the wiring line caused by the diffusion of active Cu, and realize uniform sputtered film properties. The present invention additionally yields significant effects of: being able to improve the electromigration (EM) resistance, corrosion resistance and the like; enabling the arbitrary and stable formation of a barrier layer made from titanium oxide on the top face, bottom face and periphery of the copper alloy wiring line film; and simplifying the deposition process of the copper alloy wiring line and the formation process of the barrier layer. Accordingly, the present invention is extremely useful in the formation of a copper alloy wiring line for semiconductors and the production of a sputtering target and a copper alloy wiring line for semiconductors.

## Claims

1. A copper-titanium alloy sputtering target comprising 3 at% or more and less than 15 at% of Ti and a remainder made up of Cu and unavoidable impurities, wherein a variation (standard deviation) in hardness is within 5.0 and a variation (standard deviation) in electric resistance is within 1.0 in an in-plane direction of the target.

2. The copper-titanium alloy sputtering target according to claim 1, wherein an average crystal grain size of the target is 5 to 50 µm.

3. A copper-titanium alloy semiconductor wiring line formed by using the copper-titanium alloy sputtering target according to claim 1 or claim 2.

4. A semiconductor element or a device comprising the copper-titanium alloy semiconductor wiring line according to claim 3.
